# EUROPEAN PATENT SPECIFICATION

(11) **EP 3 518 280 B1**
(45) Date of publication and mention of the grant of the patent: **04.11.2020**
(21) Application number: 18305056.6
(22) Date of filing: 25.01.2018
(51) Int. Cl.: H01L 23/48, G02B 6/12, G02B 6/13, H01L 23/522, H01L 29/786, H01L 23/66

(54) **ELECTRONIC PRODUCT HAVING EMBEDDED POROUS DIELECTRIC AND METHOD OF MANUFACTURE**
ELEKTRONISCHES PRODUKT MIT EINGEBETTETEM PORÖSEM DIELEKTRIKUM UND HERSTELLUNGSVERFAHREN
PRODUIT ÉLECTRONIQUE AYANT UN DIÉLECTRIQUE POREUX INTÉGRÉ ET PROCÉDÉ DE FABRICATION

(43) Date of publication of application: 31.07.2019
(73) Proprietor: Murata Manufacturing Co., Ltd., Kyoto 617-8555 (JP); Commissariat à l'Energie Atomique et aux Energies Alternatives, 75015 Paris (FR)
(72) Inventor: VOIRON, Frédéric, 38530 BARRAUX (FR); EL SABAHY, Julien, 38000 Grenoble (FR); FOURNEAUD, Ludovic, 38570 Le Cheylas (FR)
(74) Representative: Cabinet Beau de Loménie

(56) References cited:
- EP-A1- 1 589 605
- EP-A2- 1 256 829
- WO-A1-2017/148098
- WO-A2-2008/153245
- US-A1- 2002 109 134
- US-A1- 2014 111 291
- US-B1- 7 145 411
- JI H M ET AL: "Insertion loss characteristics of passive devices fabricated on anodized aluminum oxide layers formed on Si substrates", SENSORS AND ACTUATORS A: PHYSICAL, ELSEVIER BV, NL, vol. 157, no. 1, 24 November 2009 (2009-11-24), pages 32-35, XP026836054, ISSN: 0924-4247 [retrieved on 2009-11-24]

## Description

### Field of the Invention

The present invention relates to the field of integration and, more particularly, to electronic products, related semiconductor products, and their methods of manufacture.

### Technical Background

In recent years semiconductor products have been developed in which different electrical sub-blocks are integrated on a common substrate in order to build functions to generate, transmit, convert, detect, etc. electrical signals. Many advanced chips need to couple electronic functions to additional electronic functions or components either on the same substrate or by stacking according to packaging solutions.

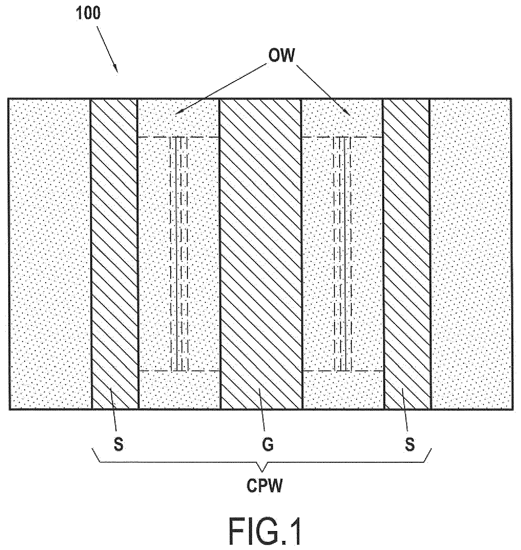

Fig.1 shows a plan view of an example integrated functional structure 100 provided on a wafer or substrate, Sub. The substrate Sub may, for example, be a silicon-on-insulator (SOI) wafer.

In the example represented in Fig.1, the functional structure 100 makes use of an electrical transmission line that is implemented as a differential SGS coplanar waveguide (CPW). The SGS coplanar waveguide includes a ground line formed of a strip-shaped electrical conductor G and two signal lines formed of two respective strip-shaped electrical conductors S. For simplicity, Fig.1 does not show the electrical connections that supply electrical signals to the signal conductors S. The conductive lines of the coplanar waveguide are formed on a dielectric layer, Diel.

In devices such as the functional structure illustrated in Fig.1, it is desirable to control with precision the velocity of the electrical signal propagating in the electrical transmission line. The electrical wave propagates with a velocity *Velec* ∝ *V_F* ∝ *c*/*√*(*ε_eff*) (V_{F} being the velocity factor, and ε_{eff} being the equivalent permittivity seen by the electrical wave travelling in the electrical transmission line composed of the mediums/medias, of permittivity εr, inserted between the propagation line(s) (signal lines) and ground return(s)). The properties of the dielectric have an important influence on the ability to control the velocity of the electrical signal.

Furthermore, in the functional structure 100, it is also desirable to assure good impedance matching of the electrical transmission line that is used to propagate the electrical signal. Indeed, improper impedance matching can result in a large fraction of the electrical wave being reflected back to the source, resulting in loss of efficiency and/or improper control of the functional structure. The impedance Z that is commonly taken as a reference is usually Z=50Ω and the magnitude of the characteristic impedance of the electrical transmission line is Z *∼√*(*L*/(*C*)), where L is the line inductance (H.m⁻¹) and C is the line capacitance (F.m⁻¹). However, in practice, using conventional dielectrics it is difficult to achieve an impedance low enough to assure good impedance matching because the minimum dimensions (critical dimensions, CDs) achievable with conventional technologies (e.g. co-fired ceramics) are limited to several dozens of µm for line width/space within a plane and for the diameter/pitch of a connecting via-hole conductor.

Prior art document EP1256829 A2 discloses an optoelectronic substrate for optical interconnections with a photonic crystal waveguide that employs an SOI base plate.

Prior art document EP1589605 A1 discloses a dielectric line comprising a dielectric strip and dielectric medium layers having different porosities from each other.

The present invention has been made in the light of the above problems.

### Summary of the Invention

The present invention provides an electronic product as recited in independent claim 1.

By suitable adjustment of the ratio of material and air/vacuum (porosity ratio) present in the porous layer a number of beneficial consequences may be achieved.

Firstly, by suitable adjustment of the porosity ratio of the porous layer, the apparent permittivity ε_{eff} of the medium may be controlled. Control of ε_{eff} enables control of the velocity factor V_{f} which is correlated to the velocity of the electrical signal in the electrical transmission line. A desired velocity of the electrical signal in the electrical transmission line, to meet particular application requirements for example, can thus be achieved.

Secondly, the inclusion of air/vacuum in the medium underlying the conductors of the electrical transmission line may result in an increase in impedance, especially if the porosity ratio is large (i.e. the fraction of air/vacuum in the porous layer is large). However, the increase of impedance (related to lowering of coupling capacitance) can be compensated for by reduction of critical dimensions (CDs), for instance: line width/spacing rules can be reduced by 2 orders of magnitude compared to the known MLCC (Multilayer Ceramic Capacitor) approach (e.g. minimum CDs < 5µm can be attained), and this allows the line impedance to be tuned to a lower value. Likewise, vertical dimensions may also be reduced by 2 orders of magnitude compared to MLCC. Thus, the overall size (CDs) can be reduced for a given target impedance and the integration density may be further improved.

Thirdly, by appropriate adjustment of the porosity ratio of the porous layer it is possible to adapt a specific layout of electronic device to different driver frequencies, while maintaining performance.

In an embodiment, the electronic product further comprises an optical waveguide formed within the silicon layer, and the porosity ratio of the porous layer in the region underlying the metal layer is configured so that the velocity of the electrical signal in the at least one electrical transmission line approaches a velocity of an optical signal propagating in the optical waveguide.

In electronic products according to embodiments of the invention, the pores in the porous layer may be tubular in shape. The tubular pores extend towards the underlying silicon layer.

Typically, the porosity ratio of the porous layer may range from 50% up to 91%.

In an embodiment, the porous layer is made of anodic aluminium oxide (AAO).

In an embodiment, the electronic product further comprises an anodization control device, formed in the silicon layer, configured to control the porosity ratio of the porous layer during manufacture. The anodization control device is configured such that the voltage drop that occurs during anodization across the region being anodized (the anodic voltage) results in the desired porosity ratio for the region. To control the anodization control device, a metal contact is provided on a surface above the porous layer, and a conductive path is provided to interconnect the metal contact to the anodization control device. In an embodiment, the metal contact comprises a via-hole conductor extending through the porous layer.

In an embodiment, the anodization control device is provided by a diode formed by a p-type region and an n-type region formed in the silicon layer. However, embodiments are not limited to the anodization control device being a diode and other passive devices (e.g., resistors) integrated into the silicon layer may be used in other embodiments.

In another embodiment, the electronic product comprises multiple anodization control devices each configured to control the porosity of a respective region of the porous layer. In an embodiment, the multiple anodization control devices are configured such that regions of different porosities are produced in the porous region. In an embodiment, the porous layer comprises a first porous region having a first porosity ratio and a second porous region having a second porosity ratio.

One or more electrical transmission lines, of same or different types, can be provided in electronic products according to embodiments of the invention. The one or more electrical transmission lines can include transmission lines of the microstrip line type, the coplanar waveguide type, the differential microstrip guide type, etc.

The one or more electrical transmission lines may be constructed on a common substrate having a porous layer with uniform porosity. Alternatively, the one or more electrical transmission lines may be provided over multiple porous regions of varying porosity ratios. This makes it possible to provide, on a common substrate, electrical transmission lines supporting different signal velocity requirements.

In an embodiment, multiple sets of anodization control devices are provided for respective different electrical transmission lines on a common substrate. The properties of each anodization control device are set as required by the porosity ratio that is desired for the porous region(s) associated with the respective electrical transmission line. Anodization in the different regions can thus be achieved by application (e.g. at the periphery of the substrate/wafer) of a common voltage to the different anodization-control devices. This facilitates the anodization process.

The present invention further provides a method of manufacturing an electronic product as recited in independent claim 12.

According to the above method, the porosity ratio achieved in the porous layer underlying the at least one electrical transmission line, and hence the effective permittivity, can be controlled in a simple manner by control of the anodization process that anodizes the metallic layer. In an embodiment, the porosity ratio of the porous layer in a region underlying the metal layer is configured based on a desired velocity of an electrical signal in the at least one electrical transmission line.

In another embodiment, anodizing the metallic layer comprises controlling the first anodization control diode and the second anodization control diode during the anodization of the metallic layer such that the formed porous layer includes a first porous region having a first porosity ratio and a second porous region having a second porosity ration. In an embodiment, the method comprises applying a common voltage to the first anodization control diode and the second anodization control diode to anodize the metallic layer to form the porous layer.

In a variation of the above method, the anodization control device(s) are provided by other types of passive devices, such as resistors for example.

### Brief Description of the Drawings

Further features and advantages of the present invention will become apparent from the following description of certain embodiments thereof, given by way of illustration only, not limitation, with reference to the accompanying drawings in which:
Figure 1 is a plan view of an example integrated semiconductor structure;
Figure 2A illustrates an example electronic product according to an embodiment of the invention;
Figure 2B illustrates an example electronic product according to another embodiment of the invention;
Figure 2C illustrates an example electronic product according to another embodiment of the invention;
Figures 3A-C illustrate porous anodic oxide/hydroxide material having different porosity ratio values, in which:

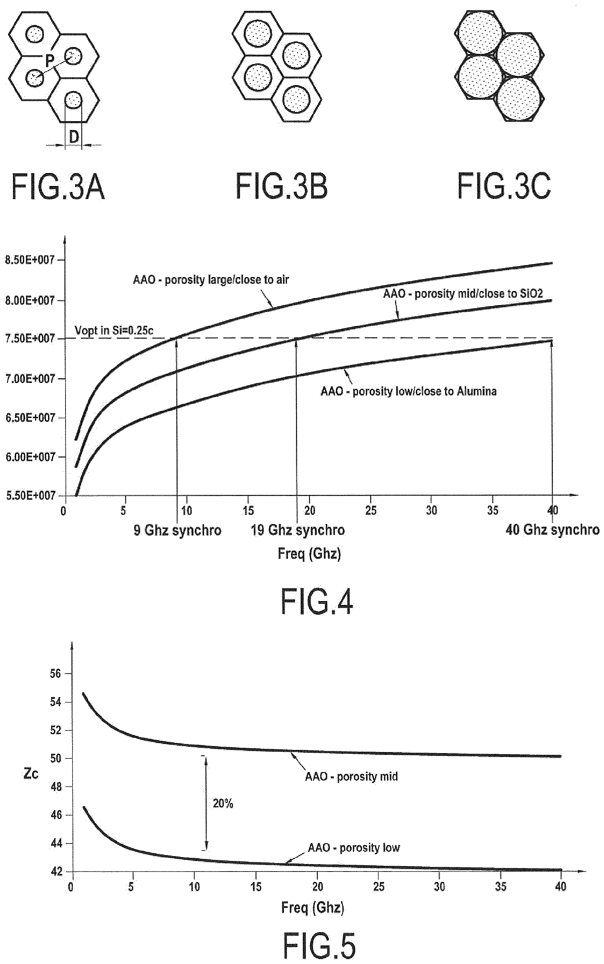

   Fig.3A illustrates a porosity ratio of 11%,
   Fig.3B illustrates a porosity ratio of 54%, and
   Fig.3C illustrates a porosity ratio of 91%;
Figure 4 is a graph showing how velocity of an electrical signal is affected by the porosity of a porous anodic oxide/hydroxide layer;
Figure 5 is a graph showing how characteristic impedance of an electrical transmission line is affected by the porosity of a porous anodic oxide/hydroxide layer;

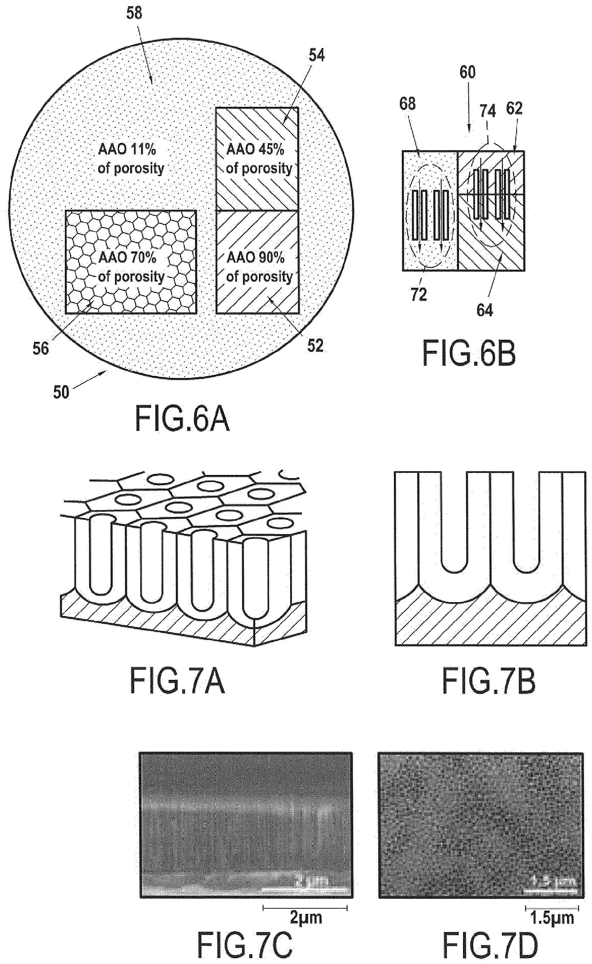

Figures 6A and 6B illustrate substrates having different regions with porous dielectric having different degrees of porosity;
Figures 7A-D illustrate the structure of pores formed in anodic aluminium oxide, in which:
   Fig.7A is a schematic view of a close-up of a section of a porous AAO layer, in perspective,
   Fig.7B represents a cross-section through a portion of Fig.7A,
   Fig.7C is a TEM high-resolution image of a porous AAO layer viewed from the side; and
   Fig.7D is a TEM high-resolution image of a porous AAO layer viewed from above.

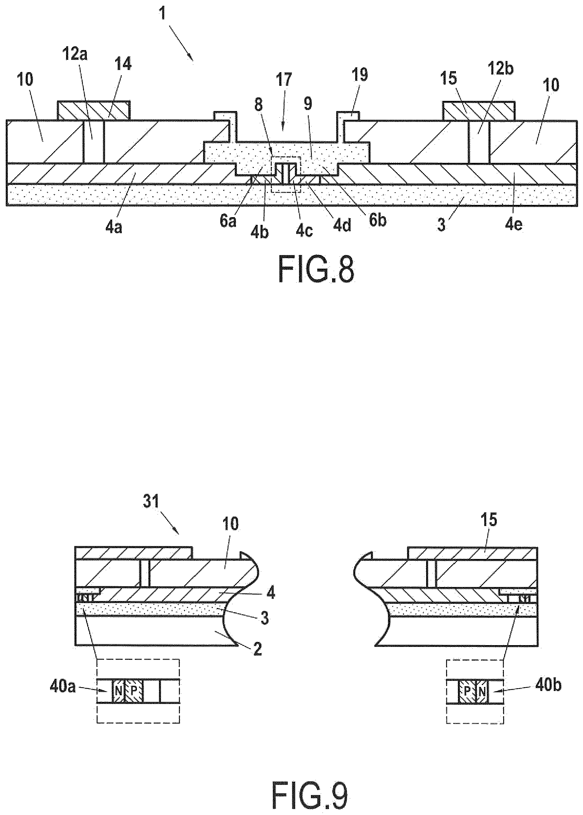

Figure 8 illustrates an electro-optical product not forming part of the invention, in cross-section;
Figure 9 is a diagram illustrating a variant embodiment including anodization-control diodes; and

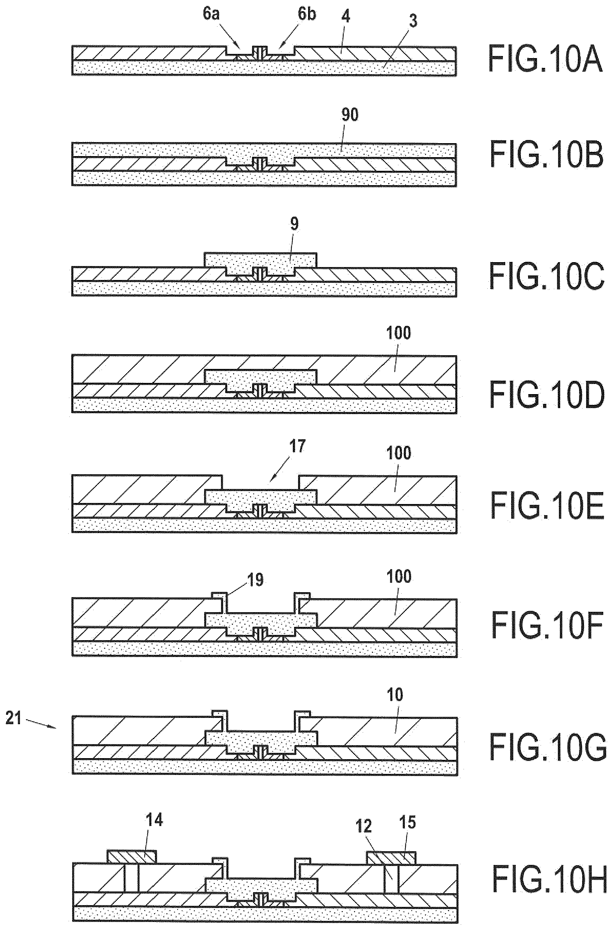

Figures 10A to 10H illustrate stages in an example method of manufacturing the electro-optical product of Fig.8.

### Detailed Description of Example Embodiments

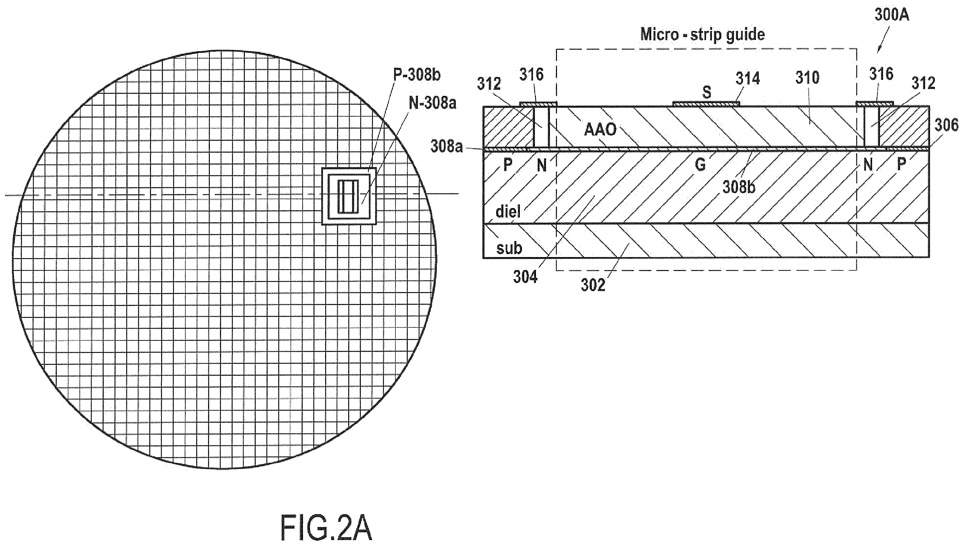

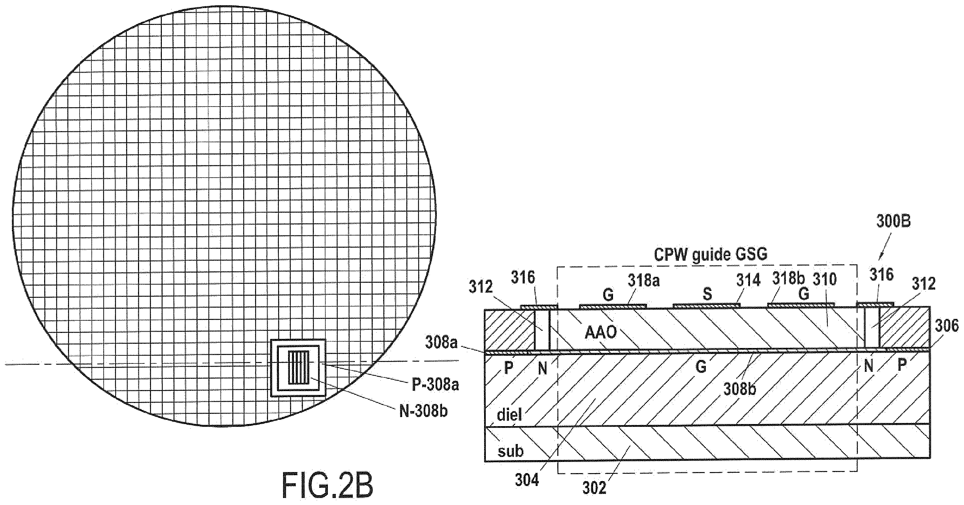

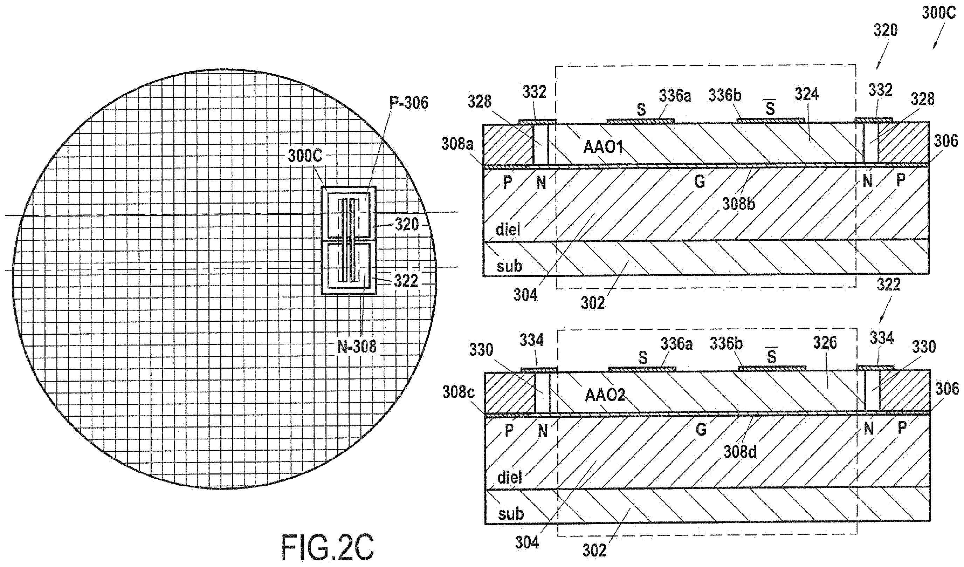

Fig. 2A illustrates a top view and a cross-section view of an example electronic product 300A according to an embodiment. (Likewise, Figs. 2B and 2C below also show top views and cross-section views of electronic products). As shown in Fig.2A, electronic product 300A includes a silicon-on-insulator (SOI) substrate formed of a silicon base substrate 302, an insulator layer 304 formed on the base substrate 302, and a thin silicon layer 306 formed on the insulator layer 304. In an embodiment, the insulator layer 304 is a buried oxide layer made of SiO₂, and the thin silicon layer 306 is a p-type silicon layer having relatively low doping (for example, doping with boron at a concentration of 1x10¹⁷ a/cm³).

Regions 308a and 308b having specified doping types and levels are formed in the thin silicon layer 306. In an embodiment, region 308b is a region of relatively light n-type doping, and region 308a is a region of relatively light p-type doping. A PN diode is formed by the regions 308a and 308b. In an embodiment, as shown in FIG. 2A, region 308a is formed as a square/rectangular-shaped ring that encloses region 308b, which may also be square/rectangular-shaped.

A porous layer 310 is formed over the silicon layer 306. In an embodiment, the porous layer 310 is made of an anodic oxide or an anodic hydroxide. For example, the porous layer 310 can be made of anodic aluminium oxide (AAO). In an embodiment, porous layer 310 is formed by anodizing a metallic layer by performing an anodization process in an electrolyte. In this anodization process an oxide or hydroxide forms on the surface of the metallic layer and the electrolyte dissolves the oxide or hydroxide layer along a preferential direction that is determined by the electrical field (i.e. usually perpendicular to the surface). As the electrolyte dissolves the oxide/hydroxide layer, fresh oxide/hydroxide forms on the surface of the metal that becomes exposed. As a result, the metallic layer is converted progressively into the porous layer 310 of anodic oxide or hydroxide having tubular pores extending substantially perpendicularly from the top surface, each pore being separated from the adjacent pore by a wall of oxide or hydroxide. The resulting porous layer 310 has cylindrical pores that are distributed according to a hexagonal pattern (see Figs.3A-3C and Figs.7A-7D). The porous layer 310 may be formed in desired portions of the metallic layer by ensuring that other portions of the metallic layer are masked before the anodization is performed. For example, as shown in Fig. 2A, non-anodized regions of the metallic layer, where the mask is applied, remain at either side of the porous layer 310 (adjacent to element 312).

Figs.3A to 3C illustrate some geometries that can be obtained by this method. Fig.3A illustrates a case where the ratio of the pore diameter to the pore pitch is 33%, yielding a porosity ratio of 11 %, where the porosity ratio is the ratio of the volume of the pores in the porous layer 310 to the volume of that porous layer 310. Fig.3B illustrates a case where the ratio of the pore diameter to the pore pitch is 66%, corresponding to a porosity ratio of 54%. Fig.3C illustrates a case where the ratio of the pore diameter to the pore pitch is 87%, (the practical maximum), and this gives a porosity ratio of 91 %.

Returning to Fig. 2A, a conductive path 312, such as a via-hole conductor, extends through the porous layer 310 to interconnect a metal contact 316, formed on a surface above the porous layer 10, with the n-type region 308b of the PN diode. This allows to control the PN diode provided by regions 308a and 308b.

In an embodiment, the PN diode formed by regions 308a and 308b provides an anodization control diode, which may be used to control the anodization process resulting in the porous layer 310 during manufacture of electronic product 300A. More specifically, the anodization control diode can be used to control the porosity ratio of the porous layer 310, which is a function of the pitch P and the diameter D of pores within the porous layer 310 (see Fig.3A). The pitch, P, between adjacent pores is correlated to the voltage applied during anodization (and adjustment of the electrolyte) and the diameter, D, of the pores can be adjusted by controlling the etch time during a subsequent isotropic etching step. As a consequence, the fraction or air (or vacuum) to the fraction of oxide/hydroxide in the structure can be adjusted (see Figs.3A to 3C) and the apparent permittivity of the medium can be adjusted within the following boundaries ε_{vacuum} < ▪ε_{porous_layer}< ε_{oxide/hydroxide (without pores}).

In another embodiment, the PN diode formed by regions 308a and 308b is replaced with a passive device of a different type, such as a resistor, formed into silicon layer 306. The passive device may be configured as an anodization control device for controlling the porosity ratio of the porous layer 310.

Returning to Fig. 2A, a metal layer 314 is formed over the porous layer 310 to provide at least one electrical transmission line. In the embodiment of FIG. 2A, the metal layer 314 includes a single signal (S) conductor line and the insulator layer 304 provides a ground, resulting in a microstrip line configuration. Connections (not shown) are provided for supplying the electrical signal to the conductor line of the microstrip line.

Using the above-described anodization control feature, in an embodiment, the porosity ratio of the porous layer 310 is configured based on a desired velocity of the electrical signal in the at least one electrical transmission line. The desired velocity of the electrical signal may be a velocity required to meet particular application requirements. Specifically, to achieve a greater velocity of the electrical signal, the porosity of the porous layer 310 is increased to reduce the effective permittivity of the medium underlying the electrical transmission line. Conversely, a lower velocity is realized by decreasing the porosity of the porous layer 310 to increase the effective permittivity of the medium underlying the electrical transmission line.

Fig.4 is a graph showing the velocity of the electrical signal in the electrical transmission line on the y-axis as a function of frequency on the x-axis. Fig.4 illustrates the fact that, by increasing the porosity of the porous layer, the apparent permittivity of the medium underlying the conductors of the electrical transmission line is reduced and it becomes possible to increase the velocity of the electrical signal. This same effect is obtained using anodic oxides and hydroxides other than AAO.

Fig.5 is a graph showing the characteristic impedance of the electrical transmission line on the y-axis as a function of frequency on the x-axis. Fig.5 illustrates how an increase in the porosity of the porous layer 310 made of anodic aluminium oxide produces an increase in the characteristic impedance of the electrical transmission line. This increase in impedance can be compensated by reducing the critical dimensions, as mentioned above.

The effects demonstrated in Figs.5 and 6 are obtained also when using anodic oxides and hydroxides other than anodic aluminium oxide.

Generally, the uniformity of the porosity of the porous regions depends on the uniformity of the anodization current that is supplied to different parts of the metal layer being anodized during the anodization process. Taking into account the fact that - in the context of integrated circuit manufacturing - it is desirable/necessary to apply the anodization voltage at the periphery of the wafer, it could be doubted whether it would be possible to achieve a suitable degree of uniformity during the anodization process. However, remarkably, suitable uniformity can be achieved when the anodization voltage is applied from a contact area at the periphery of the wafer, for the reasons explained below.

According to other embodiments, different types of electrical transmission lines can be provided by the metal layer formed over the porous layer 310. For example, in an embodiment shown in Fig. 2B, the metal layer includes a signal conductor line 314 formed in between two ground conductor lines 318a and 318b, thereby the at least one electrical transmission line including a GSG coplanar waveguide. In another embodiment, shown in Fig. 2C, the metal layer includes differential signal conductor lines 336a and 336b, thereby the at least one electrical transmission line including a differential microstrip guide. In this configuration, like the microstrip line configuration of Fig. 2A, the insulator layer 304 provides the ground. In other embodiments, multiple electrical transmission lines, of same and/or different types, can be provided by the metal layer formed over the porous layer 310.

According to other embodiments, the porous layer 310 may comprise a plurality of porous regions of varying porosity ratios. The same electrical transmission lines and/or different electrical transmission lines may be formed over the plurality of porous regions. An example electronic product 300C illustrating this concept is shown in Fig. 2C. As shown, electronic product 300C includes a first porous region 324 and a second porous region 326. The first porous region 324 is characterized by a first porosity ratio and the second porous region 326 is characterized by a second porosity ratio. The first and second porosity ratios may be configured to be different or equal.

For the purpose of independently controlling the anodization of the first and second porous regions, separate anodization control devices and associated conductive paths are provided. For example, in the embodiment of Fig. 2C, the silicon layer 306 includes p-type regions 308a and 308c and n-type regions 308b and 308d. P-type region 308a and n-type region 308b provide a first anodization control diode for the first porous region 324, and p-type region 308c and n-type region 308d provide a second anodization control diode for the second porous region 326. A conductive path 328, such as a via-hole conductor, extends through the porous region 324 to interconnect a metal contact 332 with the n-type region 308b of the first diode, to allow control of the first diode. A conductive path 330, such as a via-hole conductor, extends through the porous region 326 to interconnect a metal contact 334 with the n-type region 308d of the second diode, to allow control of the second diode.

In the example embodiment of FIG. 2C, the same electrical transmission line, a differential microstrip guide, extends over both the first and second porous regions 324 and 326. However, in other embodiments, the metal layer formed over the porous layer may include a first electrical transmission line and a second electrical transmission line, such that the first porous region 324 underlies, and couples to ground, the first electrical transmission line and the second porous region 326 underlies, and couples to ground, the second electrical transmission line. The first and second electrical transmission lines may be of the same or different types. For example, the first electrical transmission line and the second electrical transmission line may each comprise a microstrip line, a coplanar waveguide, or a differential microstrip guide.

Electronic products such as example electronic product 300C may be manufactured starting from a wafer, such as wafer 50 illustrated in Fig. 6A. As shown, wafer 50 includes different zones 52, 54, 56 of anodic aluminium oxide (AAO). In the zone 52 the porosity ratio of the AAO is 90%. In the zone 54 the porosity ratio of the AAO is 45%. In the zone 56 the porosity ratio of the AAO is 70%. The remainder 58 of the wafer 50 is provided with a layer of AAO having a porosity ratio of 11%.

By implementing specific areas having different porosities on a common substrate, it is possible to integrate structures having different electrical signal velocity requirements. Fig. 6B illustrates such integrated structures with respect to a substrate portion 60 having different zones 62, 64, 68 of AAO. In the zone 62 the porosity ratio of the AAO is 90%. In the zone 64 the porosity ratio of the AAO is 45%. In the zone 68 the porosity ratio of the AAO is 11%. In the example illustrated in Fig. 6B, a first Mach-Zehnder modulator 72 is formed in the area corresponding to AAO zone 68, and a second Mach-Zehnder modulator 74 is formed in the area corresponding to AAO zones 62 and 64 (only the positions of the optical waveguides are indicated in Fig.6B). Accordingly, the MZMs 72 and 74 can have different optical lengths. Also, in MZM 74, because the effective permittivity changes along the length of the optical waveguides, the achieved electrical velocity changes along the propagation direction. As would be understood by a person skilled in the art based on the teachings herein, the embodiment shown in Fig. 6B is not limited to Mach-Zehnder modulators embedded therein and can include any structure using at least one electrical transmission line.

Figs.7A to 7D illustrate the structure of a porous anodic aluminium oxide layer that may be provided in an electronic product, or a semiconductor product, according to certain embodiments of the invention. Fig.7A shows a section of the porous AAO layer schematically, in perspective, and at greatly enlarged scale. Fig.7B represents a cross-section through a portion of Fig.7A. Figs.7C and 7D are TEM high-resolution images of a real porous AAO layer viewed from the side, and from above, respectively.

In the following, an electro-optical product not forming part of the invention will be described with reference to Fig.8. The example will be described in the context of an electro-optical product 1 that incorporates an integrated electro-optical modulator of Mach-Zehnder type. However, it is to be understood that electro-optical products are not limited to ones that incorporate Mach-Zehnder electro-optical modulators and may include other types of electro-optical products comprising electrical and optical waveguides associated with one another in various devices. For example, without limitation, electro-optical products can include ring modulators, photodiodes, etc.

The electro-optical product 1 illustrated in Fig.8 makes use of a silicon-on-insulator substrate formed of a silicon base substrate 2 (shown in Fig.9), an insulator layer 3 formed on the base substrate 2, and a thin silicon layer 4 formed on the insulator layer 3. In this example the insulator layer 3 is a buried oxide layer made of SiO₂, and the thin silicon layer is a p-type silicon layer having relatively low doping (for example, doping with boron at a concentration of 1x10¹⁷ a/cm³). Regions 4a to 4e having specified doping types and levels are formed in the thin silicon layer. Region 4b is a region of relatively light n-type doping, and region 4d is a region of relatively light p-type doping. Region 4c is a region of very low p-type doping around the metallurgical junction between regions 4b and 4d. A PN or PIN diode is formed by the regions 4b and 4d sandwiching the region 4c. The metallurgical junction extends down to the underlying buried oxide layer 3.

Region 4a is a region of relatively heavy n-type doping, designated here as an n⁺-type region, and region 4e is a region of relatively heavy p-type doping, designated here as an p⁺-type region. The n⁺- and p⁺ regions 4a, 4e serve to facilitate electrical connection of the PIN diode's doped regions 4b and 4c to conductors of an electrical transmission line (in this example a coplanar waveguide, see below) and reduce access impedance to the metallurgical junction.

Recesses 6a, 6b are formed on either side of, and spaced somewhat from, the metallurgical junction. A zone 8 between the recesses serves as the propagation region of the optical signal. The zone 8 is surrounded by a confinement material 9 provided overlying the recessed area and filling the recesses 6a, 6b. The confinement material 9 may be made of the same material as the insulator layer 3, for example SiO₂. The confinement material 9 ensures that the proper refractive index transitions occur at the boundary surfaces between the optical path and the confinement material 9, which prevents unwanted optical signal losses resulting from parasitic reflections at these boundaries.

The confinement material 9 overlaps over the edges of the n⁺ and p⁺-regions 4a, 4e and abuts adjacent regions 10 made of a porous layer of anodic oxide or anodic hydroxide. In this example the porous regions 10 are made of anodic aluminium oxide. An opening 17 is provided through the porous anodic oxide/hydroxide layer 10 overlying the optical path, and the opening 17 is free from anodic oxide/hydroxide so as to avoid unwanted reflections that could otherwise take place at an interface between the optical path and the anodic oxide/hydroxide. The confinement material has guard portions 19 which extend up and over the edges of the porous anodic oxide/hydroxide layer 10 around the periphery of the opening 17. The guard portions 19 serve to control the porosity of the vertical surfaces of the regions 10 adjoining the guard portions 19 and prevent the formation of lateral pores.

Fig.8 illustrates a case where the same material is used for the confinement material 9 in the recesses 6a, 6b, over these recesses, and forming the guard portions 19.

Via-hole electrodes 12a, 12b having one end contacting the n⁺ and p⁺-regions 4a, 4e, respectively, are provided in via holes that pass through the anodic oxide/hydroxide regions 10, and metal strips 14, 15 corresponding to a signal line and a ground line, respectively, of an electrical transmission line make contact with the other ends of the via-hole electrodes 12a, 12b. In this manner the signal line 14 of the electrical transmission line is connected electrically to the n-type region 4b of the PIN diode, via the n⁺-region 4a, and the ground line 15 of the electrical transmission line is connected electrically to the p-type region 4d of the PIN diode, via the p⁺-region 4e. Connections (not shown) are provided for supplying the electrical signal to the conductors of the electrical transmission line and input/output connections (not shown) to the optical waveguide are also provided.

Because the porous regions 10 are formed of anodic oxide or anodic hydroxide, it is possible to form these regions so that they contain a large and adjustable percentage of air or vacuum. This enables the effective permittivity of the medium underlying the conductors of the electrical transmission line to be reduced to a specified value. Reduction in the effective permittivity enables the velocity of the electrical signal in the electrical transmission line to be brought closer to the velocity of the optical signal. The porosity ratio of the porous regions 10 can be set by appropriate control of the dimensions and spacing of the pores as shall be discussed below.

A method of manufacturing the electro-optical product not forming part of the invention will now be described with reference to Figs.10A to 10H.

According to the manufacturing method of this example, the silicon layer 4 of a Silicon On Insulator (SOI) substrate wafer is subjected to doping, preferably to attain a relatively low level of p-type doping, for example a boron concentration of 1x10¹⁷ a/cm³ (the SOI wafer comprises the p type silicon layer 4 above an insulator layer 3 which, here, is a buried oxide layer). At least one PIN diode structure is formed in the silicon layer 4 such that the vertical depth of the PN junction extends to the depth of the buried oxide 3. The PIN diode structure is implemented by implanting dopants of opposite types into respective regions which delimit a volume of silicon that has a very low p-type doping. The implantation process is followed by an activation/drive in a process step (thermal treatment) that forms a metallurgical junction having low doping level on both sides. Alternatively the desired PIN diode structure can be created by performing successive implantation steps to create corresponding highly-doped n/p sub-regions (corresponding to the p-type and n-type regions of the PIN structure) and low-doped n/p sub-regions (corresponding to the central portion of the PIN diode). To reduce access impedance to the intrinsic area, preferably contact areas to the P and N electrodes of the PIN diode are formed to have a heavier doping (or even preferably are formed as silicides) to form the n⁺-region 4a and p⁺-region 4e mentioned above.

The p and n doped regions are etched down to form recesses 6a, 6b in the vicinity of the low doped area (near the metallurgical junction) that corresponds to the waveguide for the optical signal. Fig.10A represents the resultant structure at this stage.

As shown in Fig.10B, next a material layer 90, silicon oxide in this example, is deposited on the wafer surface. The material layer 90 is patterned (see Fig.10C) so as to create the confinement material 9 ensuring the proper refractive index transitions at the boundaries between the optical path and the confinement material. The desired patterning may be created by conventional lithographic steps.

As illustrated in Fig.10D, a thick metallic film 100 is deposited over the structure. The metallic film is constituted from at least one metal layer that can be anodized. The thick metallic film 100 is preferably an aluminium film with thickness above 1µm and below 500µm. However, other metal types may be used, including Titanium (Ti), Tungsten (W), or Tantalum (Ta), for example. In this document, the expressions "anodized" and "anodic" refer to an oxide or an hydroxide being formed out of the metal layer by an anodization process in an electrolyte (see below).

As illustrated in Fig.10E the thick metallic film 100 is patterned so as to form the opening 17 in the vicinity of the optical path. This is for the purpose of avoiding unwanted reflections at the interface between the metal 100 and the optical path. The patterning may be performed by any suitable photolithographic process, for example by photolithography and etching.

Further material having an appropriate value of refractive index is deposited to coat the surfaces of the metal layer 100 at the periphery of the opening 17 and form the guard portions 19 (see Fig.10F). Preferably, this further material is selected to have the same refractive index as the confinement material 9 of Fig.10C.

The metal layer 100 is anodized by performing an anodization process in an electrolyte. In this anodization process an oxide or hydroxide forms on the surface of the metal and the electrolyte dissolves the oxide or hydroxide layer along a preferential direction that is determined by the electrical field (i.e. usually perpendicular to the surface). As the electrolyte dissolves the oxide/hydroxide layer, fresh oxide/hydroxide forms on the surface of the metal that becomes exposed. As a result, the metallic layer 100 is converted progressively into a porous layer 10 of anodic oxide or hydroxide having tubular pores extending substantially perpendicularly from the top surface, each pore being separated from the adjacent pore by a wall of oxide or hydroxide. The porous regions 10 are preferably anodic aluminium oxide regions having cylindrical pores that are distributed according to a hexagonal pattern (see Figs.3A-3C and Figs.7A-7D). Fig.10G shows the resultant structure, which may be considered to be an intermediate semiconductor product 21.

Via holes are etched through the porous regions 10, to expose the underlying n⁺ and p⁺-regions 4a,4e and then a metal layer is deposited over the structure and etched by known photolithographic processes to form the via-hole conductors 12 and the conductors 14, 15 of the electrical transmission line. As a result, the coplanar waveguide signal (S) and ground (GND) lines are connected to the respective n-type and p-type regions defining the PN junction used by the optical waveguide (as illustrated in Fig.10H).

Because the voltage set to the p-type silicon layer (specifically to region 4a) is anodic (positive) during the anodization process, the diode formed with the n⁺-region is forward biased (thus non-blocking). As a consequence, the voltage experienced by the thick metallic layer 100 is the voltage applied to the p-type silicon layer 4 at the edge of the wafer, minus the forward voltage drop V_{F} of the diode (which is of the order of 0.6V). As far as the p⁺-region is concerned the contact is ohmic and therefore has no impact on the voltage distribution (considering the low current density involved in the anodic reaction). As a consequence the anodic oxide/hydroxide regions formed over the silicon layer 4 have approximately equal porosity irrespective of whether they are formed over regions having p-type or n-type polarity.

As described above, because embodiments of the invention employ regions of anodic oxide/hydroxide whose porosity ratios can be set to desired values during manufacture, it becomes possible to create, on a common substrate (wafer), different zones having different effective permittivities (porosity ratios). For example, in a variant electro-optical product 31 that is illustrated in Fig.9, the silicon layer 4 may be formed p-type with low doping and anodization-control diodes 40a, 40b which are NP diodes, may be provided at the outside edges of the n⁺/p⁺-regions 4a, 4e. The anodization-control diodes 40a, 40b may be used to enable regions of different porosity ratio to be created.

The anodization-control diodes 40a, 40b may be formed by means of two additional implantation steps. One of these implantation steps implants p-type dopants into small zones that contact the n⁺-region 4a and p⁺-region 4e, respectively. The other of these implantation steps implants n-type dopants into adjacent small zones located towards the outside of the structure.

Subsequently, during the anodization process, an anodic voltage is applied to the silicon layer 4, and the voltage experienced by the thick metallic layer 100 corresponds to the voltage of the anodic power supply (VAnodic) decreased by the reverse-bias voltage (Vz) of the anodization-control diodes 40a, 40b described above. As a result, by properly adjusting the properties (notably Vz) of anodization-control diodes 40a, 40b provided at different locations on a wafer, different voltages can be applied to different locations on a common substrate resulting in different levels of porosity at the different locations, while still using a common VAnodic voltage that is applied to the silicon layer 4. The properties of the anodization-control diodes 40a, 40b (e.g., Vz) may be set as desired by appropriate adjustment of the doping of the NP diodes 40a, 40b. In another embodiment, the anodization control diodes 40a, 40b can be designed to be substantially identical and different anodic voltages, configured to result in different anodization levels, are applied to the different locations of the common substrate.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. An electronic product (1, 300A, 300B, 300C), comprising:
a silicon-on-insulator substrate comprising a base substrate (2, 302), an insulator layer (3, 304) on the base substrate (2, 302), and a silicon layer (4, 306) on the insulator layer (3, 304);
a porous layer (10, 310) of anodic oxide or anodic hydroxide formed over the silicon layer (4, 306); and
a metal layer (14/15, 314) formed over the porous layer (10, 310), the metal layer providing at least one electrical transmission line,
**characterized by**
an anodization control device, formed in the silicon layer (4, 306), configured to control the porosity ratio of the porous layer (10, 310) in the region underlying the metal layer (14/15, 314),
wherein the porous layer (10, 310) comprises a first porous region (324) having a first porosity ratio and a second porous region (326) having a second porosity ratio, and
wherein a porosity ratio of the porous layer (10, 310) in a region underlying the metal layer (14/15, 314) is configured based on a desired velocity of an electrical signal in the at least one electrical transmission line.

2. An electronic product (1, 300A, 300B, 300C) according to claim 1, wherein the pores in the porous layer (10, 310) are tubular in shape.

3. An electronic product (1, 300A, 300B, 300C) according to claim 1 or 2, wherein the porosity ratio of the porous layer (10, 310) in the region underlying the metal layer (14/15, 314) ranges from 50% up to 91%.

4. An electronic product (300A, 300B, 300C) according to claim 1, further comprising:
a metal contact (316) on a surface above the porous layer (310); and
a conductive path interconnecting the metal contact (316) to the anodization control device, wherein the metal contact (316) comprises a via-hole conductor (312a) extending through the porous layer (310).

5. An electronic product (300A, 300B, 300C) according to claim 1, wherein the anodization control device comprises a diode or a resistor.

6. An electronic product (300A, 300B, 300C) according to any of claims 1-5, wherein the metal layer (314) comprises a signal conductor line, thereby the at least one electrical transmission line comprising a microstrip line.

7. An electronic product (300A, 300B, 300C) according to any of claims 1-5, wherein the metal layer (314) comprises a signal conductor line in between two ground conductor lines, thereby the at least one electrical transmission line comprising a coplanar waveguide.

8. An electronic product (300A, 300B, 300C) according to any of claims 1-5, wherein the metal layer (314) comprises differential signal conductor lines, thereby the at least one electrical transmission line comprising a differential microstrip guide.

9. An electronic product (1, 300A, 300B, 300C) according to any of claims 1-8, wherein the at least one electrical transmission line comprises a first electrical transmission line and a second electrical transmission line, and wherein the first electrical transmission line is coupled to ground via the first porous region (324) and the second electrical transmission line is coupled to ground via the second porous region (326).

10. An electronic product (1, 300A, 300B, 300C) according to any of claims 1-9, further comprising:
an optical waveguide formed within the silicon layer (4, 304),
wherein the porosity ratio of the porous layer (10, 310) in the region underlying the metal layer (14/15, 314) is configured so that the velocity of the electrical signal approaches a velocity of an optical signal propagating in the optical waveguide.

11. An electronic product (1, 300A, 300B, 300C) according to any one of claims 1 to 10, wherein the porous layer (10, 310) comprises a region made of anodic aluminium oxide (AAO).

12. A method of manufacturing an electronic product, the method comprising:
forming a first p-type region (308a) and a first n-type region (308b) in the silicon layer (306) of a silicon-on-insulator substrate, the silicon-on-insulator substrate comprising a base substrate (302), an insulator layer (304) on the base substrate, and the silicon layer (306) on the insulator layer (304), the first p-type region (308a) and the first n-type region (308b) forming a first anodization control diode;
forming a second p-type region (308c) and a second n-type region (308d) in the silicon layer (306), the second p-type region (308c) and the second n-type region (308d) forming a second anodization control diode;
forming a metallic layer over the silicon layer (306);
anodizing the metallic layer, using the first and second anodization control diodes, to form a porous layer (310) of anodic oxide or anodic hydroxide, wherein anodizing the metallic layer comprises controlling the first anodization control diode and the second anodization control diode such that the formed porous layer (310) comprises a first porous region (324) having a first porosity ratio and a second porous region (326) having a second porosity ratio; and
forming a metal layer (314) over the porous layer (310), the metal layer (314) providing at least one electrical transmission line.

13. The method according to claim 12, comprising applying a common voltage to the first anodization control diode and the second anodization control diode to anodize the metallic layer to form the porous layer (310).

14. The method according to claim 12 or 13, wherein a porosity ratio of the porous layer (310) in a region underlying the metal layer (314) is configured based on a desired velocity of an electrical signal in the at least one electrical transmission line.

## Patentansprüche

1. Elektronisches Produkt (1, 300A, 300B, 300C), umfassend:
ein Silizium-auf-Isolator-Substrat, umfassend ein Basissubstrat (2, 302), eine Isolatorschicht (3, 304) auf dem Basissubstrat (2, 302) und eine Siliziumschicht (4, 306) auf der Isolatorschicht (3, 304),
eine poröse Schicht (10, 310) aus anodischem Oxid oder anodischem Hydroxid, die über der Siliziumschicht (4, 306) gebildet ist, und
eine über der porösen Schicht (10, 310) gebildete Metallschicht (14/15, 314), wobei die Metallschicht mindestens eine elektrische Übertragungsleitung bereitstellt,
**gekennzeichnet durch**
eine Anodisierungssteuervorrichtung, die in der Siliziumschicht (4, 306) ausgebildet und dazu konfiguriert ist, das Porositätsverhältnis der porösen Schicht (10, 310) in dem Bereich unter der Metallschicht (14/15, 314) zu steuern,
wobei die poröse Schicht (10, 310) einen ersten porösen Bereich (324) mit einem ersten Porositätsverhältnis und einen zweiten porösen Bereich (326) mit einem zweiten Porositätsverhältnis umfasst, und
wobei ein Porositätsverhältnis der porösen Schicht (10, 310) in einem unter der Metallschicht (14/15, 314) liegenden Bereich auf der Grundlage einer gewünschten Geschwindigkeit eines elektrischen Signals in der mindestens einen elektrischen Übertragungsleitung konfiguriert ist.

2. Elektronisches Produkt (1, 300A, 300B, 300C) nach Anspruch 1, wobei die Poren in der porösen Schicht (10, 310) röhrenförmig sind.

3. Elektronisches Produkt (1, 300A, 300B, 300C) nach Anspruch 1 oder 2, wobei das Porositätsverhältnis der porösen Schicht (10, 310) in dem unter der Metallschicht (14/15, 314) liegenden Bereich von 50 % bis zu 91 % reicht.

4. Elektronisches Produkt (300A, 300B, 300C) nach Anspruch 1, ferner umfassend:
einen Metallkontakt (316) auf einer Oberfläche über der porösen Schicht (310) und
eine Leiterbahn, die den Metallkontakt (316) mit der Anodisierungssteuervorrichtung verbindet, wobei der Metallkontakt (316) einen Durchgangslochleiter (312a) aufweist, der sich durch die poröse Schicht (310) erstreckt.

5. Elektronisches Produkt (300A, 300B, 300C) nach Anspruch 1, wobei die Anodisierungssteuervorrichtung eine Diode oder einen Widerstand umfasst.

6. Elektronisches Produkt (300A, 300B, 300C) nach einem der Ansprüche 1 bis 5, wobei die Metallschicht (314) eine Signalleiterleitung umfasst, wodurch die mindestens eine elektrische Übertragungsleitung eine Mikrostreifenleitung umfasst.

7. Elektronisches Produkt (300A, 300B, 300C) nach einem der Ansprüche 1 bis 5, wobei die Metallschicht (314) eine Signalleiterleitung zwischen zwei Masseleiterleitungen umfasst, wodurch die mindestens eine elektrische Übertragungsleitung einen koplanaren Wellenleiter umfasst.

8. Elektronisches Produkt (300A, 300B, 300C) nach einem der Ansprüche 1 bis 5, wobei die Metallschicht (314) differentielle Signalleiterleitungen umfasst, wodurch die mindestens eine elektrische Übertragungsleitung einen differentiellen Mikrostreifenleiter umfasst.

9. Elektronisches Produkt (1, 300A, 300B, 300C) nach einem der Ansprüche 1 bis 8, wobei die mindestens eine elektrische Übertragungsleitung eine erste elektrische Übertragungsleitung und eine zweite elektrische Übertragungsleitung umfasst, und wobei die erste elektrische Übertragungsleitung über den ersten porösen Bereich (324) mit Masse gekoppelt ist und die zweite elektrische Übertragungsleitung über den zweiten porösen Bereich (326) mit Masse gekoppelt ist.

10. Elektronisches Produkt (1, 300A, 300B, 300C) nach einem der Ansprüche 1 bis 9, ferner umfassend:
einen innerhalb der Siliziumschicht gebildeten optischen Wellenleiter (4, 304),
wobei das Porositätsverhältnis der porösen Schicht (10, 310) in dem Bereich unter der Metallschicht (14/15, 314) so konfiguriert ist, dass sich die Geschwindigkeit des elektrischen Signals einer Geschwindigkeit eines optischen Signals annähert, das sich in dem optischen Wellenleiter ausbreitet.

11. Elektronisches Produkt (1, 300A, 300B, 300C) nach einem der Ansprüche 1 bis 10, wobei die poröse Schicht (10, 310) einen Bereich aus anodischem Aluminiumoxid (AAO) umfasst.

12. Verfahren zur Herstellung eines elektronischen Produkts, wobei das Verfahren umfasst:
Bilden eines ersten p-Typ-Bereichs (308a) und eines ersten n-Typ-Bereichs (308b) in der Siliziumschicht (306) eines Silizium-auf-Isolator-Substrats, wobei das Silizium-auf-Isolator-Substrat ein Basissubstrat (302), eine Isolatorschicht (304) auf dem Basissubstrat und die Siliziumschicht (306) auf der Isolatorschicht (304) umfasst, wobei der erste p-Typ-Bereich (308a) und der erste n-Typ-Bereich (308b) eine erste Anodisierungssteuerdiode bilden,
Bilden eines zweiten p-Typ-Bereichs (308c) und eines zweiten n-Typ-Bereichs (308d) in der Siliziumschicht (306), wobei der zweite p-Typ-Bereich (308c) und der zweite n-Typ-Bereich (308d) eine zweite Anodisierungssteuerdiode bilden,
Bilden einer metallischen Schicht über der Siliziumschicht (306),
Anodisieren der metallischen Schicht unter Verwendung der ersten und zweiten Anodisierungssteuerdiode, um eine poröse Schicht (310) aus anodischem Oxid oder anodischem Hydroxid zu bilden, wobei das Anodisieren der metallischen Schicht das Steuern der ersten Anodisierungssteuerdiode und der zweiten Anodisierungssteuerdiode umfasst, so dass die gebildete poröse Schicht (310) einen ersten porösen Bereich (324) mit einem ersten Porositätsverhältnis und einen zweiten porösen Bereich (326) mit einem zweiten Porositätsverhältnis umfasst, und
Bilden einer Metallschicht (314) über der porösen Schicht (310), wobei die Metallschicht (314) mindestens eine elektrische Übertragungsleitung bereitstellt.

13. Verfahren nach Anspruch 12, umfassend das Anlegen einer gemeinsamen Spannung an die erste Anodisierungssteuerdiode und die zweite Anodisierungssteuerdiode, um die metallische Schicht zu anodisieren, um die poröse Schicht zu bilden (310).

14. Verfahren nach Anspruch 12 oder 13, wobei ein Porositätsverhältnis der porösen Schicht (310) in einem unter der Metallschicht (314) liegenden Bereich auf der Grundlage einer gewünschten Geschwindigkeit eines elektrischen Signals in der mindestens einen elektrischen Übertragungsleitung konfiguriert wird.

## Revendications

1. Produit électronique (1, 300A, 300B, 300C) comprenant :
un substrat en silicium sur isolant comprenant un substrat de base (2, 302), une couche d'isolant (3, 304) sur le substrat de base (2, 302), et une couche de silicium (4, 306) sur la couche d'isolant (3, 304) ;
une couche poreuse (10, 310) en oxyde anodique ou hydroxyde anodique, formée sur la couche de silicium (4, 306) ; et
une couche métallique (14/15, 314) formée au-dessus de la couche poreuse (10, 310), la couche métallique fournissant au moins une ligne de transmission électrique,
**caractérisé par**
un dispositif de commande d'anodisation, formé dans la couche de silicium (4, 306), configuré pour commander le taux de porosité de la couche poreuse (10, 310) dans la région sous-jacente à la couche métallique (14/15, 314),
dans lequel la couche poreuse (10, 310) comprend une première région poreuse (324) ayant un premier taux de porosité et une deuxième région poreuse (326) ayant un deuxième taux de porosité, et
dans lequel un taux de porosité de la couche poreuse (10, 310) dans une région sous-jacente à la couche métallique (14/15, 314) est configuré sur la base de la vitesse souhaitée d'un signal électrique dans l'au moins une ligne de transmission électrique.

2. Produit électronique (1, 300A, 300B, 300C) selon la revendication 1, dans lequel les pores dans la couche poreuse (10, 310) ont une forme tubulaire.

3. Produit électronique (1, 300A, 300B, 300C) selon la revendication 1 ou 2, dans lequel le taux de porosité de la couche poreuse (10, 310) dans la région sous-jacente à la couche métallique (14/15, 314) est situé dans la plage allant de 50 % à 91 %.

4. Produit électronique (300A, 300B, 300C) selon la revendication 1, comprenant en outre :
un contact métallique (316) sur une surface au-dessus de la couche poreuse (310) ; et
une piste conductrice interconnectant le contact métallique (316) au dispositif de commande d'anodisation,
dans lequel le contact métallique (316) comprend un conducteur à trou traversant (312a) s'étendant à travers la couche poreuse (310).

5. Produit électronique (300A, 300B, 300C) selon la revendication 1, dans lequel le dispositif de commande d'anodisation comprend une diode ou une résistance.

6. Produit électronique (300A, 300B, 300C) selon l'une quelconque des revendications 1 à 5, dans lequel la couche métallique (314) comprend une ligne de conducteur de signal, moyennant quoi l'au moins une ligne de transmission électrique comprend une ligne en microruban.

7. Produit électronique (300A, 300B, 300C) selon l'une quelconque des revendications 1 à 5, dans lequel la couche métallique (314) comprend une ligne de conducteur de signal entre deux lignes de conducteur de terre, moyennant quoi l'au moins une ligne de transmission électrique comprend un guide d'onde coplanaire.

8. Produit électronique (300A, 300B, 300C) selon l'une quelconque des revendications 1 à 5, dans lequel la couche métallique (314) comprend des lignes de conducteur de signal différentielles, moyennant quoi l'au moins une ligne de transmission électrique comprend un guide en microbande différentiel.

9. Produit électronique (1, 300A, 300B, 300C) selon l'une quelconque des revendications 1 à 8, dans lequel l'au moins une ligne de transmission électrique comprend une première ligne de transmission électrique et une deuxième ligne de transmission électrique, et dans lequel la première ligne de transmission électrique est couplée à la terre via la première région poreuse (324) et la deuxième ligne de transmission électrique est couplée à la terre via la deuxième région poreuse (326).

10. Produit électronique (1, 300A, 300B, 300C) selon l'une quelconque des revendications 1 à 9, comprenant en outre :
un guide d'onde optique formé à l'intérieur de la couche de silicium (4, 304),
dans lequel le taux de porosité de la couche poreuse (10, 310) dans la région sous-jacente à la couche métallique (14/15, 314) est configuré de façon que la vitesse du signal électrique s'approche de la vitesse d'un signal optique se propageant dans le guide d'onde optique.

11. Produit électronique (1, 300A, 300B, 300C) selon l'une quelconque des revendications 1 à 10, dans lequel la couche poreuse (10, 310) comprend une région faite en oxyde d'aluminium anodique (AAO).

12. Procédé de fabrication d'un produit électronique, le procédé comprenant :
la formation d'une première région de type p (308a) et d'une première région de type n (308b) dans la couche de silicium (306) d'un substrat en silicium sur isolant, le substrat en silicium sur isolant comprenant un substrat de base (302), une couche d'isolant (304) sur le substrat de base, et la couche de silicium (306) sur la couche d'isolant (304), la première région de type p (308a) et la première région de type n (308b) formant une première diode de commande d'anodisation ;
la formation d'une deuxième région de type p (308c) et d'une deuxième région de type n (308d) dans la couche de silicium (306), la deuxième région de type p (308c) et la deuxième région de type n (308d) formant une deuxième diode de commande d'anodisation ;
la formation d'une couche métallique au-dessus de la couche de silicium (306) ;
l'anodisation de la couche métallique, utilisant les première et deuxième diodes de commande d'anodisation, pour former une couche poreuse (310) en oxyde anodique ou hydroxyde anodique, laquelle anodisation de la couche métallique comprend la commande de la première diode de commande d'anodisation et de la deuxième diode de commande d'anodisation de façon que la couche poreuse formée (310) comprenne une première région poreuse (324) ayant un premier taux de porosité et une deuxième région poreuse (326) ayant un deuxième taux de porosité ; et
la formation d'une couche métallique (314) au-dessus de la couche poreuse (310), la couche métallique (314) fournissant au moins une ligne de transmission électrique.

13. Procédé selon la revendication 12, comprenant l'application d'une tension commune à la première diode de commande d'anodisation et à la deuxième diode de commande d'anodisation pour anodiser la couche métallique pour former la couche poreuse (310).

14. Procédé selon la revendication 12 ou 13, dans lequel un taux de porosité de la couche poreuse (310) dans une région sous-jacente à la couche métallique (314) est configuré sur la base de la vitesse souhaitée d'un signal électrique dans l'au moins une ligne de transmission électrique.
